# EUROPEAN PATENT APPLICATION

(11) **EP 4 576 949 A1**
(43) Date of publication of application: **25.06.2025**
(21) Application number: 23948669.9
(22) Date of filing: 20.10.2023
(51) Int. Cl.: H05K 1/18

(54) **POWER SUPPLY DEVICE**

(71) Applicant: Delta Electronics, Inc., Taoyuan City 33370 (TW)
(72) Inventor: YEN, Chun-Ching, Taoyuan City 32063 (TW); TSAO, Yue, Taoyuan City 32063 (TW); CHIN, Ying-Chieh, Taoyuan City 32063 (TW); ZHANG, Shaodong, Taoyuan City 32063 (TW); ZHANG, Zhi-Liang, Taoyuan City 32063 (TW); WEN, Sheng-Yu, Taoyuan City 32063 (TW)
(74) Representative: Uexküll & Stolberg
(86) International application number: PCT/CN2023/125678
(87) International publication number: WO 2025/081469

(57) **Abstract**

A power supply device includes a power circuit module and a planar transformer. The power circuit module includes a first printed circuit board and a power conversion module. The first printed circuit board has a first surface and a second surface opposite to the first surface. The power conversion module is disposed on the first surface. The planar transformer includes a magnetic core assembly, at least one second printed circuit board and at least one winding module. The magnetic core assembly includes a first magnetic core and a second magnetic core. At least one of the first magnetic core and the second magnetic core is located beside the first printed circuit board. The at least one second printed circuit board is arranged between the first magnetic core and the second magnetic core. The at least one second printed circuit board includes a first winding. The winding module is arranged between the first magnetic core and the second magnetic core. The winding module includes a second winding and an encapsulation layer. In addition, at least a portion of an outer surface of the second winding is covered by the encapsulation layer.

## Description

### FIELD OF THE INVENTION

The present invention relates to a power supply device, and more particularly to a power supply device with the combination of a planar transformer and a power circuit module in a stack manner like Lego bricks.

### BACKGROUND OF THE INVENTION

A power supply device is used to convert the received input power into the output power and provide the output power to be used for a load. Generally, a power supply device includes multiple electronic components and a circuit board. Among the electronic components, a transformer is the most critical component. In conventional power supply device, all electronic components are fixedly disposed on the circuit board. Consequently, after all required electronic components for the conventional power supply device are prepared, the power supply device starts to be fabricated and assembled. In other words, the production process is highly inconvenient. Moreover, since all electronic components in conventional power supply devices are permanently fixed on the circuit board and unable to be separated, it is unable to maintain individual components. During maintenance, it is necessary to completely disassemble the power supply device, and thus the entire power supply device cannot be recycled for reuse.

Therefore, there is a need of providing a power supply device to obviate the drawbacks encountered from the prior arts.

### SUMMARY OF THE INVENTION

The present disclosure provides a power supply device. The power supply device is a combination of a planar transformer and a power circuit module in a stack manner like LEGO bricks. Consequently, the power supply device of the present disclosure can be produced more conveniently. In addition, some components in the power supply device can be repaired individually.

In accordance with an aspect of the present disclosure, a power supply device is provided. The power supply device includes at least one power circuit module and a planar transformer. The at least one power circuit module includes a first printed circuit board and a power conversion module. The first printed circuit board has a first surface and a second surface opposite to the first surface. The power conversion module is disposed on the first surface. The planar transformer includes a magnetic core assembly, at least one second printed circuit board and at least one winding module. The magnetic core assembly includes a first magnetic core and a second magnetic core. The at least one of the first magnetic core and the second magnetic core is located beside the first printed circuit board. The at least one second printed circuit board is arranged between the first magnetic core and the second magnetic core. The at least one second printed circuit board includes a first winding. The at least one winding module is arranged between the first magnetic core and the second magnetic core. The at least one winding module includes a second winding and an encapsulation layer. At least a portion of an outer surface of the second winding is covered by the encapsulation layer.

### BRIEF DESCRIPTION OF THE DRAWINGS

FIG. 1 is a schematic view illustrating a power supply device according to a first embodiment of the present disclosure;
FIG. 2 is a schematic exploded view illustrating the power supply device as shown in FIG. 1;
FIG. 3 is a schematic view illustrating a structure of a second winding of a planar transformer as shown in FIG. 1;
FIG. 4 is a schematic view illustrating an internal wiring of a second printed circuit board of the planar transformer as shown in FIG. 1;
FIG. 5 is a schematic view illustrating a variation of the second winding of the planar transformer as shown in FIG. 2; and
FIG. 6 is a schematic view illustrating a power supply device according to a second embodiment of the present disclosure.

### Description of reference numerals:

1A, 1B: power supply device
7: power circuit module
70: first printed circuit board
71: power conversion module
700, 200: first surface
701, 201: second surface
1: planar transformer
2: magnetic core assembly
3: second printed circuit board
4: winding module
20: first magnetic core
21: second magnetic core
30: first winding
40, 40a: second winding
41: encapsulation layer
22: first side leg
23: second side leg
24: middle leg
31: first hollow hole
42: second hollow hole
44: first pin base region
5: conducting element
32: second perforation
45: second pin base region
46, 46a: second conducting pin
400: surface
401: recessed portion
460: first bent portion
461: second bent portion
462: U-shaped structure
33: auxiliary winding
34: shielding structure
72: first perforation

### DETAILED DESCRIPTION OF THE PREFERRED EMBODIMENT

The present disclosure will now be described more specifically with reference to the following embodiments. It is to be noted that the following descriptions of preferred embodiments of this invention are presented herein for purpose of illustration and description only. It is not intended to be exhaustive or to be limited to the precise form disclosed.

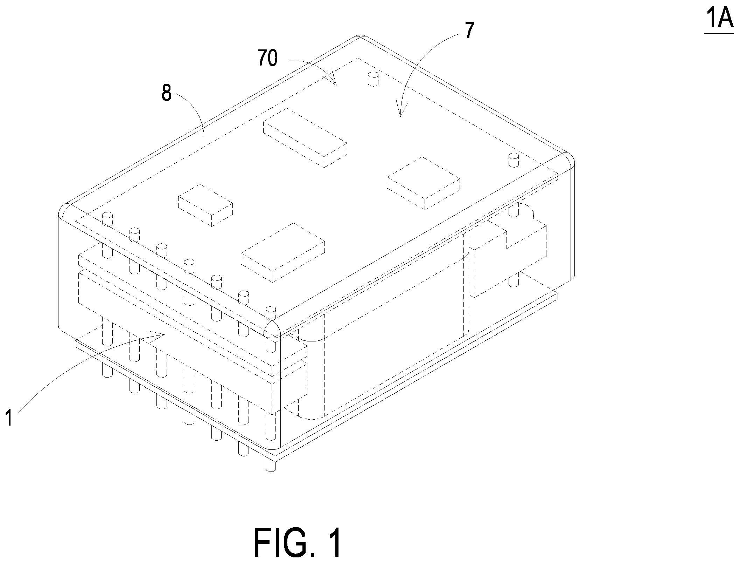

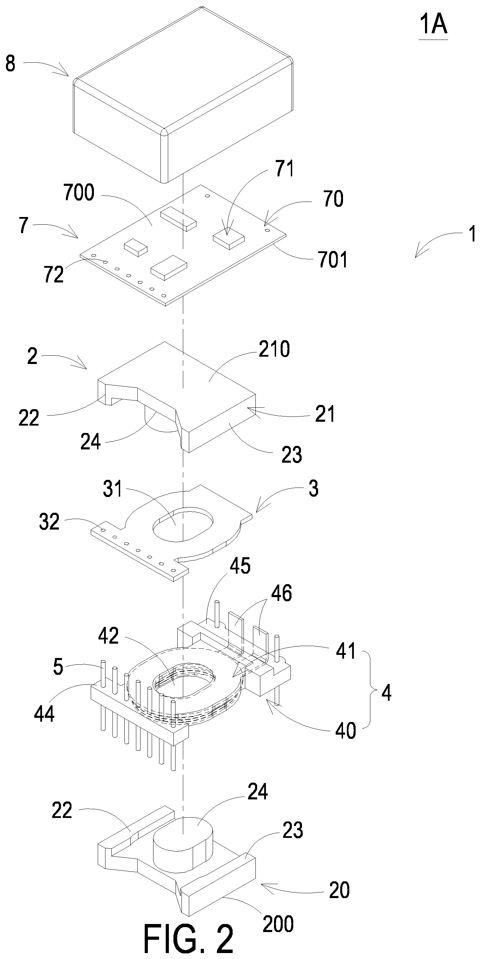

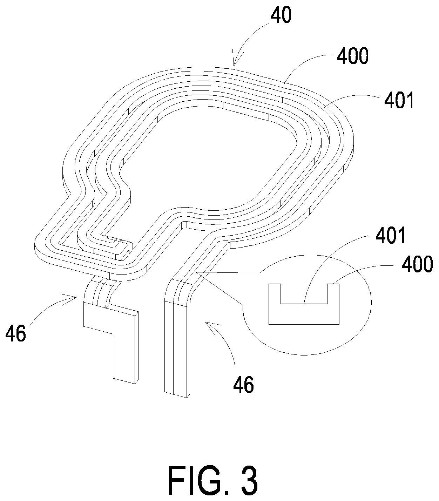

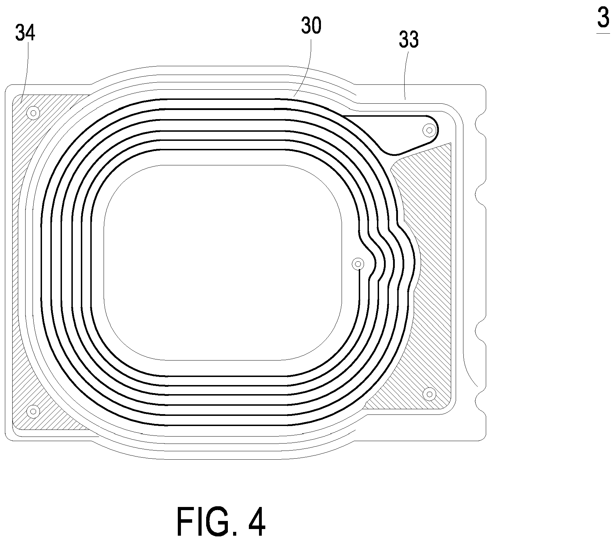

Please refer to FIGS. 1, 2, 3 and 4. FIG. 1 is a schematic view illustrating a power supply device according to a first embodiment of the present disclosure. FIG. 2 is a schematic exploded view illustrating the power supply device as shown in FIG. 1. FIG. 3 is a schematic view illustrating a structure of a second winding of a planar transformer as shown in FIG. 1. FIG. 4 is a schematic view illustrating an internal wiring of a second printed circuit board of the planar transformer as shown in FIG. 1. The power supply device 1A of this embodiment converts the received input power into the output power and provides the output power to be used for a load. The power supply device 1A includes at least one power circuit module 7 and a planar transformer 1. The power circuit module 7 includes a first printed circuit board 70 and a power conversion module 71. The first printed circuit board 70 has a first surface 700 and a second surface 701 opposite to the first surface 700. The power conversion module 71 is disposed on the first surface 700.

In some embodiments, the power conversion module 71 converts the input power into transitional power, and the power conversion module 71 includes at least one electronic component. Preferably but not exclusively, the at least one electronic component includes a switching element, controller, diode, resistor, a multilayered ceramic capacitor, or the like. In some embodiment, as shown in FIG. 1, all electronic components of the power conversion module 71 are individually and independently arranged on the first surface 700. In other embodiments, after all electronic components of the power conversion module 71 are encapsulated into an integrated module, the integrated module is disposed on the first surface 700.

In some embodiments, the power circuit module 7 further includes a power factor correction (PFC) module (not shown), an electromagnetic interference (EMI)/radio frequency interference (RFI) module and an input capacitor. The power factor correction (PFC) module (not shown), the electromagnetic interference (EMI)/radio frequency interference (RFI) module and the input capacitor are arranged on the first surface 700. The PFC module is used for power factor correction of the input power. The EMI/RFI module is used to suppress electromagnetic interference and radio frequency interference. The input capacitor is used for voltage stabilization.

The planar transformer 1 in this embodiment meets the requirements for ultra-thin high-frequency circuits and is suitable for being assembled and tested in a fully automated manner. The planar transformer 1 includes a magnetic core assembly 2, at least one second printed circuit board 3 and at least one winding module 4.

The magnetic core assembly 2 includes a first magnetic core 20 and a second magnetic core 21. The first magnetic core 20 and the second magnetic core 21 disposed on two opposite sides of the second printed circuit board 3. In addition, at least one of the first magnetic core 20 and the second magnetic core 21 is located beside the first printed circuit board 70. As shown in FIG. 2, the second magnetic core 21 is located beside the first printed circuit board 70, and the first printed circuit board 70 (or the power circuit module 7) is located at an outermost side of the power supply device 1A.

The at least second printed circuit board 3 includes one second printed circuit board 3 or a plurality of second printed circuit boards 3. In the example of FIG. 2, one second printed circuit board 3 is shown. The second printed circuit board 3 is arranged between the first magnetic core 20 and the second magnetic core 21. As shown in FIG. 4, the second printed circuit board 3 includes a first winding 30. The first winding 30 is formed in the second printed circuit board 3. In addition, the first winding 30 is defined by traces or conductors in the second printed circuit board 3.

The at least one winding module 4 includes one winding module 4 or a plurality of winding modules 4. In the example of FIG. 2, one winding module 4 is shown. The winding module 4 is arranged between the first magnetic core 20 and the second magnetic core 21, or the winding module 4 is arranged between the second printed circuit board 3 and the first winding 20. In addition, the winding module 4 includes a second winding 40 and an encapsulation layer 41. Preferably but not exclusively, the second winding 40 is formed by stamping a conductive sheet, and the conductive sheet is a copper sheet.

The encapsulation layer 41 is formed on the second winding 40 by using a plastic injection molding process. At least a portion of an outer surface of the second winding 40 is covered by the encapsulation layer 41. Due to the arrangement of the encapsulation layer 41, the planar transformer 1 can comply with safety standards. In this embodiment, the second printed circuit board 3 and the winding module 4 are separate components. In other words, the second printed circuit board 3 and the winding module 4 are not integrally formed.

As mentioned above, the power supply device 1A includes the power circuit module 7 and the planar transformer 1. The power circuit module 7 and the planar transformer 1 are assembled in a stack manner like LEGO bricks. Since the power circuit module 7 and the planar transformer 1 can be assembled or disassembled independently, it is not necessary to prepare all electronic components before the power supply device 1A is fabricated. That is, the power circuit module 7 and the planar transformer 1 can be assembled in different locations and then collected and assembled as the power supply device 1A. Consequently, the power supply device 1A can be fabricated more conveniently. Moreover, since the power circuit module 7 and the planar transformer 1 are combined in a stack manner, the power circuit module 7 and the planar transformer 1 can be repaired or maintained individually without the need of fully disassembling the power supply device 1A. Consequently, the utilization rate of the components in the power supply device 1A will be enhanced. Moreover, the planar transformer 1 includes the second printed circuit board 3 and the winding module 4, which are separate components. The second printed circuit board 3 includes the first winding 30, and the winding module 4 includes the second winding 40. In other words, the windings in the planar transformer 1 are divided into two parts, i.e., the first winding 30 and the second winding 40, and these two parts are independent components. In other words, the number of layers in the second printed circuit board 3 of the planar transformer 1 is reduced because the second winding 40 is formed on the winding module 4. When compared to conventional planar transformer with a single circuit board, the second printed circuit board 3 has fewer layers. Consequently, the production cycle of the planar transformer 1 is shortened, the manufacturing process of the second printed circuit board 3 is simplified, and the fault tolerance is increased. In this way, the production cost of the planar transformer 1 is reduced. Furthermore, the adjustability of the planar transformer 1 of the present invention is particularly advantageous.

In some embodiments, the first winding 30 is formed as one of a primary winding and a secondary winding of the planar transformer 1, and the second winding 40 is formed as the other of the primary winding and the secondary winding of the planar transformer 1. The thickness of the second winding 40 is greater than or equal to 0.01mm and less than or equal to 1.5mm, and the turn number of the second winding 40 is greater than or equal to two. Moreover, the safety insulation distance between the first winding 30 and the second winding 40 is 0.4 mm. The safety insulation distance can be implemented with the thickness of the encapsulation layer 41 or the thickness of the second printed circuit board 3. Moreover, the thickness of the encapsulation layer 41 is greater than or equal to 0.4mm and less than or equal to 0.8mm.

In some embodiments, the magnetic core assembly 2 includes a first side leg 22, a second side leg 23 and a middle leg 24. The first side leg 22 and the second side leg 23 are located on opposite sides of the magnetic core assembly 2. The middle leg 24 is arranged between the first side leg 22 and the second side leg 23. In addition, the first side leg 22, the second side leg 23 and the middle leg 24 are arranged between the first magnetic core 20 and the second magnetic core 21. As shown in FIG. 2, each of the first side leg 22, the second side leg 23 and the middle leg 24 includes two sub-legs. One of the sub-legs of the first side leg 22, one of the sub-legs of the second side leg 23 and one of the sub-legs of the middle leg 24 are connected with the first magnetic core 20. The other sub-leg of the first side leg 22, the other sub-leg of the second side leg 23 and the other sub-leg of the middle leg 24 are connected with the second magnetic core 21. In other embodiments, each of the first side leg 22, the second side leg 23 and the middle leg 24 is an individual structure and connected with the first magnetic core 20 or the second magnetic core 21.

In some embodiments, the second printed circuit board 3 includes a first hollow hole 31, and the winding module 4 includes a second hollow hole 42. The first hollow hole 31 runs through the second printed circuit board 3, and the second hollow hole 42 runs through the winding module 4. The first hollow hole 31 and the second hollow hole 42 are aligned with the middle leg 24 of the magnetic core assembly 2. When the first magnetic core 20 and the second magnetic core 21 of the magnetic core assembly 2 are interlocked on the second printed circuit board 3 and the winding module 4 from two opposite sides of the planar transformer 1, the middle leg 24 is penetrated through the first hollow hole 31 and the second hollow hole 42.

In some embodiments, the encapsulation layer 41 includes a first pin base region 44. The first pin base region 44 is located on a first side of the encapsulation layer 41. The first pin base region 44 includes a first upper surface and a first lower surface. The first upper surface and the first lower surface are in parallel with the second printed circuit board 3. The planar transformer 1 further includes at least one conducting element 5, e.g., a first conducting pin. The conducting element 5 is formed at the location of the first pin base region 44 of the encapsulation layer 41 when the encapsulation layer 41 is formed over the second winding 40 through the injection molding process. The conducting element 5 is substantially perpendicular to the first upper surface and the first lower surface of the first pin base region 44, and a portion of the conducting element 5 is covered by the encapsulation layer 41. The conducting element 5 is exposed to the first upper surface and the first lower surface of the first pin base region 44. In addition, the conducting element 5 is extended in the direction perpendicular to the first pin base region 44. The portion of conducting element 5 exposed outside the first pin base region 44 is electrically connected to the traces or conductors of the second printed circuit board 3 by a soldering process. For example, the conducting element 5 is electrically connected to the first winding 30 by the soldering process. In addition, the conducting element 5 is inserted into a system board (not shown).

In other embodiments, the first printed circuit board 70 includes at least one first perforation 72. The number and the position of the at least one first perforation 72 correspond to the number and the position of the at least one conducting element 5. The at least one conducting element 5 is penetrated through the corresponding first perforation 72, so that the at least one conducting element 5 is assembled with the first printed circuit board 70. Consequently, the power circuit module 7 and the planar transformer 1 can be combined in the stack manner like LEGO blocks. In addition, the conducting element 5 is electrically connected to the power conversion module 71 through the traces (not shown) or conductors (not shown) of the first printed circuit board 70.

In some embodiments, the second printed circuit board 3 includes at least one second perforation 32. Each of the at least one second perforation 32 is aligned with the corresponding conducting element 5, and the corresponding conducting element 5 is penetrated through the corresponding second perforation 32. Consequently, at least a portion of the conducting element 5 is electrically connected with the traces or conductors of the second printed circuit board 3.

In other embodiments, the encapsulation layer 41 includes a second pin base region 45. The second pin base region 45 is located on a second side of the encapsulation layer 41 that is opposite to the first side of the encapsulation layer 41. The second pin base region 45 includes a second upper surface and a second lower surface. The second upper surface and the second lower surface are in parallel with the second printed circuit board 3. The winding module 4 further includes at least one second conducting pin 46. In FIG. 3, two second conducting pins 46 are shown. At least a portion of the second conducting pin 46 is disposed on the second pin base region 45. One end of each second conducting pin 46 is connected with the corresponding end of the second winding 40 and disposed in the second pin base region 45. The other end of each second conducting pin 46 is exposed to the second upper surface or the second lower surface of the second pin base region 45 and extended in the direction perpendicular to the second pin base region 45. The two second conducting pins 46 are inserted into the system board (not shown).

In some embodiments, the two second conducting pins 46 are integrally formed with the two opposite ends of the second winding 40. In other words, the two second conducting pins 46 are directly extended from the two opposite ends of the second winding 40. For allowing the other end of each second conducting pin 46 to be exposed to the second upper surface or second lower surface of the second pin base region 45 and extended in the direction perpendicular to the second pin base region 45, each second conducting pin 46 is bent at least once at a 90-degree angle from the corresponding end of the second winding 40.

In some embodiments, the second winding 40 includes a surface 400 and a recessed portion 401. The recessed portion 401 is concavely formed in the surface 400 of the second winding 40. Due to the recessed portion 401, the skin effect can be reduced. Consequently, the conversion efficiency of the planar transformer 1 will be increased. In other embodiments, the second conducting pin 46 is integrally formed with the corresponding end of the second winding 40, and the surface of the second conducting pin 46 also has the recessed portion 401.

In some embodiments, the area of the first surface 700 of the first printed circuit board 70 is equal to the area of the second surface 701 of the first printed circuit board 70. The area of a first surface 200 of the first magnetic core 20 is equal to the area of a second surface 210 of the second magnetic core 21. In addition, the area of the second surface 701 of the first printed circuit board 70 is less than or equal to 1.5 times the area of the second surface 210 of the second magnetic core 21. If the first printed circuit board 70 is located beside the second magnetic core 21, the area of the overlap region between the second surface 701 of the first printed circuit board 70 and the second surface 210 of the second magnetic core 21 is at least 70% of the area of the second surface 701 of the first printed circuit board 70 or 70% of the area of the second surface 210 of the second magnetic core 21. If the first printed circuit board 70 is located beside the first magnetic core 20, the area of the overlap portion between the second surface 701 of the first printed circuit board 70 and the first surface 200 of the first magnetic core 20 is at least 70% of the area of the second surface 701 of the first printed circuit board 70 or 70% of the area of the first surface 200 of the first magnetic core 20.

Please refer to FIG. 4 again. In addition to the first winding 30, the second printed circuit board 3 further includes at least one auxiliary winding 33 and at least one shielding structure 34. Each auxiliary winding 33 and each shielding structure 34 are disposed in any one or more layers in the second printed circuit board 3. It is noted that the positions of each auxiliary winding 33 and each shielding structure 34 are not limited. The auxiliary winding 33 and the first winding 30 are collaboratively formed as a primary winding or a secondary winding of the planar transformer 1. The auxiliary winding 33 is served as a control signal line. In addition, the wire diameter of the auxiliary winding 33 is smaller than or equal to the wire diameter of the first winding 30. The shielding structure 34 is a metallic conductor structure to suppress EMI electromagnetic interference. In some embodiments, the second printed circuit board 3 is a layered structure with at least one layer. The at least one layer of the layered structure of the second printed circuit board 3 includes the first winding 30. In addition, each layer of the layered structure of the second printed circuit board 33 includes at least one of the first winding 30, the auxiliary winding 33 and the shielding structure 34.

In some embodiments, after the power circuit module 7 and the planar transformer 1 are combined in the stack manner like LEGO bricks, a portion of the power circuit module 7 and a portion of the planar transformer 1 are covered with resin through a potting method for encapsulation. Consequently, the safety strength of the power supply device 1A is enhanced. In other embodiments, a portion of the conducting element 5 (i.e., the first conducting pin) and a portion of the second conducting pin 46 are exposed outside the resin after encapsulation. Consequently, the conducting element 5 and the second conducting pin 46 can be inserted into the system board.

In some embodiments, as shown in FIG. 2, the power supply device 1A includes a hollow cover 8. The assembled structure of the power circuit module 7 and the planar transformer 1 is accommodated within the hollow cover 8. Accordingly, the inner components of the power supply device 1A can be effectively protected.

In other embodiments, the power supply device 1A includes two power circuit modules, and the two power circuit modules are respectively arranged on two opposite outer sides of the power supply device 1A. The first printed circuit board 70 of one of the two power circuit modules and the second magnetic core 21 are located beside each other, and the first printed circuit board of the other of the two power circuit modules and the first magnetic core 20 are located beside each other.

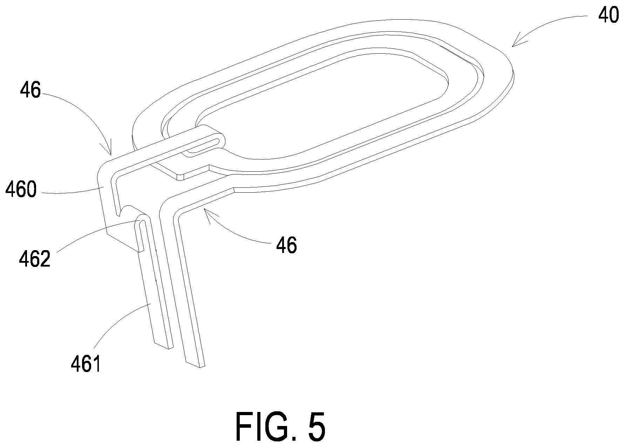

FIG. 5 is a schematic view illustrating a variant example of the second winding of the planar transformer as shown in FIG. 2. As shown in FIG. 5, at least one second conducting pin 46 includes a first bent portion 460 and a second bent portion 461. The first bent portion 460 is connected between the corresponding end of the second winding 40 and the second bent portion 461, and a portion of the first bent portion 460 is disposed in the second pin base region 45. In addition, the first bent portion 460 is formed by bending an end of the second winding 40 at least one time. A portion of the second bent portion 461 is exposed to the second upper surface or the second lower surface of the second pin base region 45 and extended in a direction perpendicular to the second pin base region 45. In addition, the second bent portion 461 is formed by bending an end of the first bent portion 460 one time. Consequently, a bent site of the second bent portion 461 includes a U-shaped structure 462. Due to the U-shaped structure 462, the wire length of the second winding 40 is increased.

As mentioned above, the number of the printed circuit boards and winding modules in the planar transformer of the present disclosure can be arbitrarily adjusted according to the practical requirements. For example, in a variant example, the planar transformer includes two winding modules and one printed circuit board.

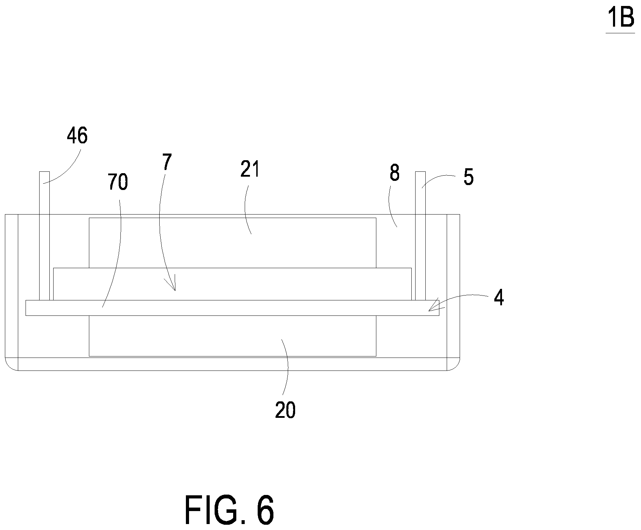

FIG. 6 is a schematic view illustrating a power supply device according to a second embodiment of the present disclosure. The structure of the power supply device 1B of this embodiment is similar to the power supply device 1A of FIG. 1. Component parts and elements corresponding to those of FIG. 1A are designated by identical numeral references, and detailed descriptions thereof are omitted. In the power supply device 1A of FIG. 1, the power circuit module 7 is located at the outermost side of the power supply device 1A. In the power supply device 1B of this embodiment, the power circuit module 7 is arranged between the first magnetic core 20 and the second magnetic core 21 of the core magnetic assembly 2. Consequently, the first magnetic core 20 and the second magnetic core 21 are located beside the first printed circuit board 70.

As mentioned above, the present disclosure provides a power supply device. The power supply device includes a power circuit module and a planar transformer. The power circuit module and the planar transformer are assembled in a stack manner like LEGO bricks. Since the power circuit module and the planar transformer can be assembled or disassembled independently, it is not necessary to prepare all electronic components before the power supply device is fabricated. That is, the power circuit module and the planar transformer can be assembled in different locations and then collected and assembled as the power supply device. Consequently, the power supply device can be fabricated more conveniently. Moreover, since the power circuit module and the planar transformer are combined in a stack manner like LEGO bricks, the power circuit module and the planar transformer can be repaired or maintained individually without the need of fully disassembling the power supply device. Consequently, the utilization rate of the components in the power supply device will be enhanced. Moreover, the planar transformer includes the second printed circuit board and the winding module, which are separate components. The second printed circuit board includes the first winding, and the winding module includes the second winding. In other words, the windings in the planar transformer are divided into two parts, i.e., the first winding and the second winding, and these two parts are independent components. In other words, the number of layers in the second printed circuit board of the planar transformer is reduced because the second winding is formed on the winding module. When compared to conventional planar transformer with a single circuit board, the second printed circuit board has fewer layers. Consequently, the production cycle of the planar transformer is shortened, the manufacturing process of the second printed circuit board is simplified, and the fault tolerance is increased. In this way, the production cost of the planar transformer is reduced. Furthermore, the adjustability of the planar transformer of the present invention is particularly advantageous.

## Claims

1. A power supply device, comprising:
at least one power circuit module comprising a first printed circuit board and a power conversion module, wherein the first printed circuit board has a first surface and a second surface opposite to the first surface, and the power conversion module is disposed on the first surface; and
a planar transformer comprising:
a magnetic core assembly comprising a first magnetic core and a second magnetic core, wherein at least one of the first magnetic core and the second magnetic core is located beside the first printed circuit board;
at least one second printed circuit board arranged between the first magnetic core and the second magnetic core, wherein the at least one second printed circuit board comprises a first winding; and
at least one winding module arranged between the first magnetic core and the second magnetic core, wherein the at least one winding module comprises a second winding and an encapsulation layer, and at least a portion of an outer surface of the second winding is covered by the encapsulation layer.

2. The power supply device according to claim 1, wherein the power circuit module is located at an outermost side of the power supply device, and the second magnetic core is located beside the first printed circuit board.

3. The power supply device according to claim 1, wherein the planar transformer further comprises at least one conducting element, and a portion of the at least one conducting element is covered by the encapsulation layer, wherein the first printed circuit board comprises at least one first perforation, wherein a number and a position of the at least one first perforation correspond to a number and a position of the at least one conducting element, and the at least one conducting element is penetrated through the corresponding first perforation, so that the at least one conducting element is assembled with the first printed circuit board.

4. The power supply device according to claim 1, wherein the power supply device further comprises a hollow cover, wherein an assembled structure of the power circuit module and the planar transformer is accommodated within the hollow cover.

5. The power supply device according to claim 1, wherein the first winding is formed as one of a primary winding and a secondary winding of the planar transformer, and the second winding is formed as the other of the primary winding and the secondary winding of the planar transformer.

6. The power supply device according to claim 1, wherein a thickness of the second winding is greater than or equal to 0.01mm and less than or equal to 1.5mm, and a thickness of the encapsulation layer is greater than or equal to 0.4mm and less than or equal to 0.8mm.

7. The power supply device according to claim 1, wherein the planar transformer further comprises at least one conducting element, and a portion of the at least one conducting element is covered by the encapsulation layer, wherein the at least one conducting element is electrically connected with the first winding and assembled with the first printed circuit board, so that the at least one conducting element is electrically connected with the power conversion module.

8. The power supply device according to claim 7, wherein the encapsulation layer comprises a first pin base region, and the first pin base region is located on a first side of the encapsulation layer, wherein the first pin base region comprises a first upper surface and a first lower surface, and the first upper surface and the first lower surface are in parallel with the second printed circuit board, wherein the at least one conducting element comprises at least one first conducting pin, the first conducting pin is disposed on the first pin base region, and a portion of the first conducting pin is covered by the encapsulation layer, wherein the first conducting pin is exposed to the first upper surface and the first lower surface of the first pin base region, and the first conducting pin is extended in a direction perpendicular to the first pin base region, wherein the first conducting pin is electrically connected with the first winding.

9. The power supply device according to claim 8, wherein the second printed circuit board comprises at least one second perforation, wherein each of the at least one second perforation is aligned with the corresponding conducting element, and the corresponding conducting element is penetrated through the corresponding second perforation.

10. The power supply device according to claim 8, wherein the encapsulation layer further comprises a second pin base region, and the second pin base region is located on a second side of the encapsulation layer that is opposite to the first side of the encapsulation layer, wherein the second pin base region comprises a second upper surface and a second lower surface, and the second upper surface and the second lower surface are in parallel with the second printed circuit board, wherein the winding module further comprises at least one second conducting pin, the second conducting pin is disposed on the second pin base region, and a portion of the second conducting pin is covered by the encapsulation layer, wherein the second conducting pin is exposed to the second upper surface and the second lower surface of the second pin base region, and the second conducting pin is extended in a direction perpendicular to the second pin base region, wherein the second conducting pin is electrically connected with the second winding.

11. The power supply device according to claim 10, wherein the second conducting pin comprises a first bent portion and a second bent portion, the first bent portion is connected between the second winding and the second bent portion, and a portion of the first bent portion is disposed in the second pin base region, wherein the first bent portion is formed by bending an end of the second winding at least one time, a portion of the second bent portion is exposed to the second upper surface or the second lower surface of the second pin base region and extended in a direction perpendicular to the second pin base region, and the second bent portion is formed by bending an end of the first bent portion one time, wherein a bent site of the second bent portion includes a U-shaped structure.

12. The power supply device according to claim 1, wherein a portion of the power circuit module and a portion of the planar transformer are covered with resin for encapsulation.

13. The power supply device according to claim 10, wherein a portion of the power circuit module and a portion of the planar transformer are covered with resin for encapsulation, and a portion of the first conducting pin and a portion of the second conducting pin are exposed outside the resin after encapsulation.

14. The power supply device according to claim 1, wherein the second winding is formed by stamping a conductive sheet.

15. The power supply device according to claim 14, wherein the second winding further comprises a surface and a recessed portion, and the recessed portion is concavely formed in the surface of the second winding.

16. The power supply device according to claim 1, wherein the second printed circuit board is a layered structure with at least one layer, and the second printed circuit board further comprises at least one auxiliary winding and at least one shielding structure, wherein the auxiliary winding and the first winding are collaboratively formed as a primary winding or a secondary winding of the planar transformer, the auxiliary winding is served as a control signal line, and the shielding structure is a metallic conductor structure, wherein the at least one layer of the layered structure of the second printed circuit board comprises the first winding, and each layer of the layered structure of the second printed circuit board comprises at least one of the first winding, the auxiliary winding and the shielding structure.

17. The power supply device according to claim 1, wherein the power supply device comprises two power circuit modules, and the two power circuit modules are respectively arranged on two opposite outer sides of the power supply device, wherein the first printed circuit board of one of the two power circuit modules and the second magnetic core are located beside each other, and the first printed circuit board of the other of the two power circuit modules and the first magnetic core are located beside each other.

18. The power supply device according to claim 1, wherein an area of the first surface of the first printed circuit board is equal to an area of the second surface of the first printed circuit board, an area of a first surface of the first magnetic core is equal to an area of a second surface of the second magnetic core, and the area of the second surface of the first printed circuit board is less than or equal to 1.5 times the area of the second surface of the second magnetic core, wherein when the first printed circuit board is located beside the second magnetic core, an area of an overlap region between the second surface of the first printed circuit board and the second surface of the second magnetic core is at least 70% of the area of the second surface of the first printed circuit board or 70% of the area of the second surface of the second magnetic core, wherein when the first printed circuit board is located beside the first magnetic core, an area of an overlap portion between the second surface of the first printed circuit board and the first surface of the first magnetic core is at least 70% of the area of the second surface of the first printed circuit board or 70% of the area of the first surface of the first magnetic core.

19. The power supply device according to claim 1, wherein the power conversion module comprises at least one switching element, at least one controller, at least one diode, at least one resistor, and at least one multilayer ceramic capacitor.
